Europäisches Patentamt

European Patent Office

Office européen des brevets

(11) Publication number: **0 109 445**
**B1**

# EUROPEAN PATENT SPECIFICATION

(45) Date of publication of patent specification: **31.01.90**

(51) Int. Cl.⁵: **H 01 L 27/14, H 04 N 3/14**

(21) Application number: **83901618.5**

(22) Date of filing: **19.05.83**

(86) International application number:
**PCT/JP83/00150**

(87) International publication number:
**WO 83/04344 08.12.83 Gazette 83/28**

(54) **CHARGE TRANSFER DEVICES FOR MULTIPLEXING SIGNALS.**

(30) Priority: **21.05.82 JP 86258/82**

(43) Date of publication of application:
**30.05.84 Bulletin 84/22**

(45) Publication of the grant of the patent:
**31.01.90 Bulletin 90/05**

(84) Designated Contracting States:
**DE FR GB NL**

(56) References cited:
**GB-A-1 453 341**
**JP-A-51 105 284**
**US-A-4 028 671**
**US-A-4 211 937**

**CARLO H. SEQUIN, and one other (Author)**
**Takeishi Yoshiyuki, and one other (Kanyaku)**
**"Denka Tenso Device, CCD, BBD no Kiso to Oyo"**
**20. February. 1978 (20.02.78) Kindai Kagakusha**
**P. 54.**

(73) Proprietor: **SONY CORPORATION**
**7-35 Kitashinagawa 6-Chome Shinagawa-ku**
**Tokyo 141 (JP)**

(72) Inventor: **SATO, Maki Sony Corporation**
**7-35, Kitashinagawa 6-chome**
**Shinagawa-ku Tokyo 141 (JP)**
Inventor: **HASHIMOTO, Takeo Sony**
**Corporation**
**7-35, Kitashinagawa 6-chome**
**Shinagawa-ku Tokyo 141 (JP)**

(74) Representative: **Thomas, Christopher Hugo**
**et al**
**D Young & Co 10 Staple Inn**
**London WC1V 7RD (GB)**

Courier Press, Leamington Spa, England.

## Description

This invention relates to charge transfer devices for multiplexing signals.

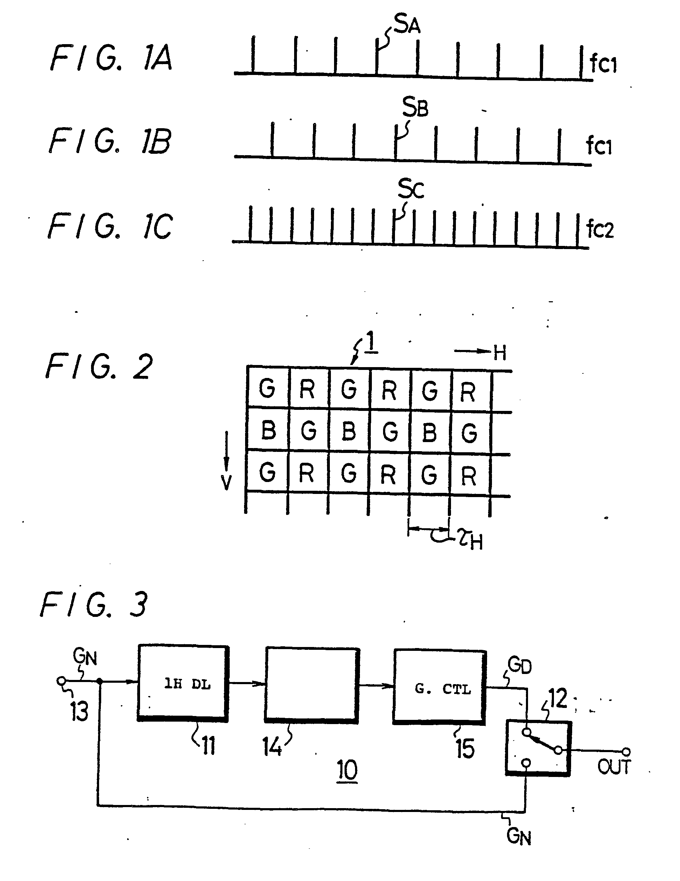

A first time series signal (such as a sampling output) SA as shown in Figure 1A and a second time series signal SB (Figure 1B), the phase of which is different from that of the first signal SA by 180°, may be required to be multiplexed to form a third time series signal SC of twice the frequency as shown in Figure 1C. Such signal processing is required where the number of picture elements of a charge coupled device (CCD) used as, for example, an image sensing element is reduced, but the resolution in the horizontal or vertical direction is increased.

When a colour filter 1 having a checkered colour alignment as shown in Figure 2 is utilized to generate from the CCD an image signal, particularly a green primary colour signal G, the colour alignment is different by $\tau H$ (where $\tau H$ is the alignment pitch of the picture elements in the horizontal direction) between odd and even lines. Accordingly, with respect to the green signal G, on the odd line appears the time series signal of Figure 1A, while on the even line appears the time series signal of Figure 1B.

Therefore, if the green signals G having such respective time series are made simultaneous and then multiplexed, the green signal information derived from each horizontal line is doubled, so that the horizontal resolution can be greatly improved as compared with the case in which the green signals are not multiplexed.

Figure 3 shows an example of a suitable signal processing circuit, which is formed of a delay element 11 of one horizontal period (1H) and a switching circuit 12 for multiplexing. To an input terminal 13 is supplied a green signal (voltage) GN which is derived from the CCD. Thus, when the green signal delayed by 1H (delayed output GD) and the current green signal (non-delayed output GN) are multiplexed with each other, the delayed output GD must be in the form of a voltage level.

Accordingly, when the delay element 11 is formed of a CCD, at the output stage of the delay element 11 there must be provided an output circuit 14 which converts a signal charge to a voltage. Because the output circuit 14 has a temperature characteristic, a difference in signal level occurs between the delayed output GD and the non-delayed output GN. As a result, it is usual that in addition to the output circuit 14, there is provided a level adjusting circuit 15.

US patent specification US—A—4 211 937 discloses a multi-channel charge coupled transfer device comprising a plurality of charge transfer channels connected to a merging shift register. There is disclosed a multiplexed electrode per bit structure, having N charge transfer channels successively displaced by one electrode at the input and output of the structure in the charge transfer direction, and with the corresponding electrodes of the channels arranged in the direction normal to the charge transfer direction connected to receive the same N-phase clock pulse signal. A rectangular configuration is obtained by disposing coupling cells at the input and output of the structure. The merging shift register is driven by a clock signal having a frequency N times that of the N-phase clock pulse signal so as serially to receive signal charge packets from the charge transfer channels and successively transfer the signal charge packets to the output node.

According to the present invention there is provided a charge transfer device for multiplexing signals, the device comprising:

first and second charge coupled transfer channels for transferring signal charges along one direction and arranged in lines one below the other, each said channel having a plurality of transfer electrodes extending over said channel transversely to the charge transport direction and being aligned with transfer electrodes of the other channel; and

a third charge coupled transfer channel coupled to said first and second channels for transferring signal charges along the same direction and having a plurality of transfer electrodes which extend transversely over said third channel and over said first and second channels adjacent to the coupling region;

said transfer electrodes of said first and second channels receiving first clock signals with said respective aligned transfer electrodes of both channels receiving said first clock signals at different phases; and

said transfer electrodes of said third channel receiving second clock signals which have a frequency twice that of said first clock signals;

whereby a pair of input signals supplied to said first and second channels are alternately supplied to said third channel and thence to the output of said third channel.

According to the present invention there is also provided a charge transfer device for multiplexing signals, the device comprising:

first, second and third charge coupled transfer channels for transferring signal charges along one direction and arranged in lines one below the other;

a fourth charge coupled transfer channel coupled to said first, second and third channels for transferring signal charges along the same direction;

a first plurality of common transfer electrodes extending transversely over said first, second and third channels, each of said first plurality of transfer electrodes having portions offset from each other in charge transfer direction such that a particular transfer electrode portion over said first channel is offset from a transfer electrode portion over said second channel which in turn is offset from a transfer electrode portion over said third transfer channel, and transfer electrode portions over the respective channels belonging to different transfer electrodes being transversely aligned; and

a second plurality of transfer electrodes extending transversely over said fourth channel and over said first, second and third channels, only adjacent to where said first, second and third channels are coupled to said fourth channel;

said first plurality of transfer electrodes receiving first clock signals; and

said second plurality of transfer electrodes receiving second clock signals which have a frequency three times that of said first clock signals;

whereby a group of input signals supplied to said first, second and third channels are alternately supplied to said fourth channel and thence to the output of said fourth channel.

The invention will now be described by way of example with reference to the accompanying drawings, throughout which like parts are referred to by like references, and in which:

Figure 1 is a diagram of signals to be multiplexed;

Figure 2 shows a colour filter;

Figure 3 is a block diagram of a colour signal processing circuit;

Figure 4 is a block diagram showing an example of a video signal generating circuit for explaining the invention;

Figure 5 is a diagram showing a charge transfer device applied to a video signal generating circuit;

Figure 6 is a waveform diagram of a transfer clock pulse;

Figures 7 and 8 are charge transfer diagrams;

Figure 9 is a diagram similar to Figure 5 showing an alternative circuit; and

Figure 10 is a waveform diagram of a transfer clock pulse.

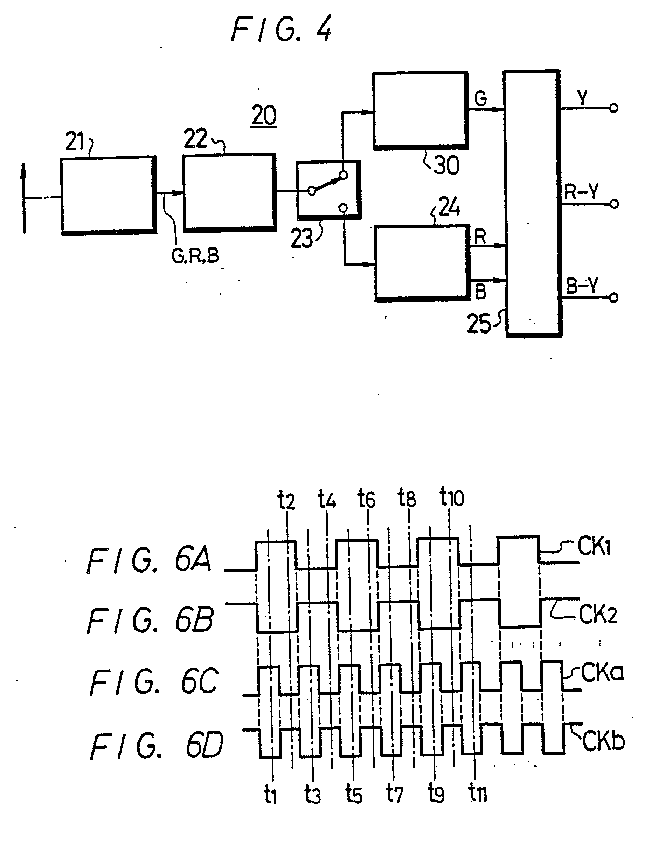

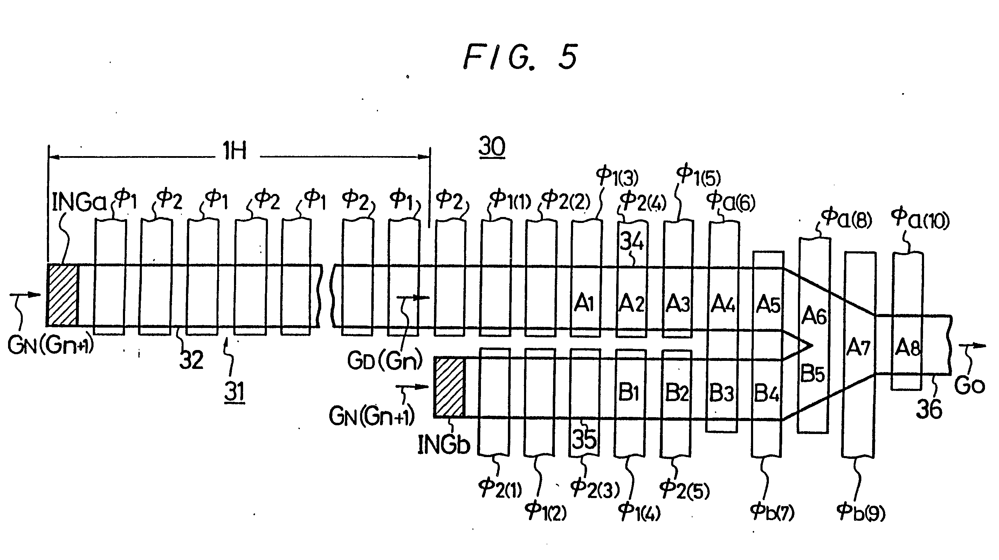

Figure 4 shows a video signal generating circuit which employs a colour filter 1 as shown in Figure 2. Thus, from a CCD 21 are derived dot sequential signals G, R and B which are then converted to voltages by an output circuit 22. The dot sequential signals converted to voltage levels are separated into a green signal G and a red and blue line sequential signal R/B by a signal separating circuit 23. The line sequential signal R/B is further supplied to a circuit 24 in which it is converted to simultaneous signals R and B.

On the other hand, the green signal G is supplied to a charge transfer device 30 in which it is multiplexed, and is then supplied to a matrix circuit 25 together with the simultaneous signals R and B from which a desired video signal is produced. In this case there are formed a luminance signal Y and a pair of colour difference signals R-Y and B-Y.

The charge transfer device 30 corresponds to the signal processing circuit (multiplexer) shown in Figure 3, and has the function mentioned before, that is, after the green signal GN has been delayed by 1H, the delayed output GD and non-delayed output GN are multiplexed with each other.

Figure 5 shows an example of the charge transfer device 30 used. For convenience of explanation, this drawing is a conceptual construction diagram in which transfer channels formed in the element are shown flat.

A delay element 31 of 1H is formed by a CCD having a surface channel or a buried channel, and a transfer channel 32. A green signal GN is supplied to an input gate INGa. The transfer of signal charges is carried out by a 2-phase clock system, so that there are provided 2-phase transfer electrodes φ1 and φ2. The form and operation of the transfer electrodes φ1 and φ2 can utilize well-known techniques.

The green signal delayed by 1H, namely the delayed output GD, is supplied to a first transfer channel 34 as signal charges. The first transfer channel 34 is constructed the same as the transfer channel 32 for the delay element. Similarly, the non-delayed output GN is applied to an input gate INGb of a second transfer channel 35. The first and second transfer channels 34 and 35 are coupled as shown to form a third transfer channel 36. The first and second transfer channels 34 and 35 are equal in channel length.

The transfer of the signal charges is carried out by 2-phase transfer clocks CK1 and CK2 of opposite phase (Figures 6A and 6B) which are supplied to the transfer electrodes φ1 and φ2 formed on the delay element transfer channel 32 and the first transfer channel 34. The frequencies of the transfer clocks CK1 and CK2 are the same as the frequency of the clock (sampling clock) supplied to the CCD 21 used as the image sensing element.

The transfer electrodes φ1 and φ2 formed on the second transfer channel 35 are positioned relative to the transfer electrodes φ1 and φ2 formed on the first transfer channel 34, such that the alignment pitch thereof is displaced from that of the latter by one pitch. Accordingly, when the last transfer electrode formed on the first transfer channel 34 is φ1 as shown in the Figure, the last transfer electrode formed on the second transfer channel 35 is φ2.

The transfer electrodes φ1 and φ2 are formed up to just before where the transfer channels 34 and 35 couple. After that, transfer electrodes φa and φb for the third transfer channel 36 are provided. The transfer electrodes φa and φb positioned on the transfer channels 34 and 35 are provided in common. To these transfer electrodes φa and φb are supplied 2-phase transfer clocks CKa and CKb (Figures 6C and 6D), each having a clock frequency of $2f_{c1}=f_{c2}$.

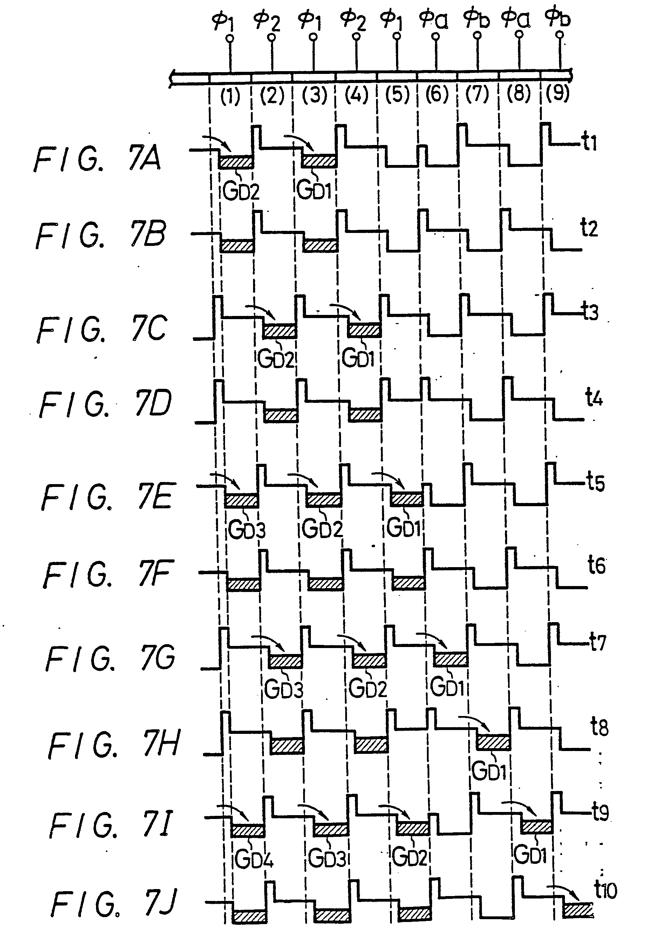

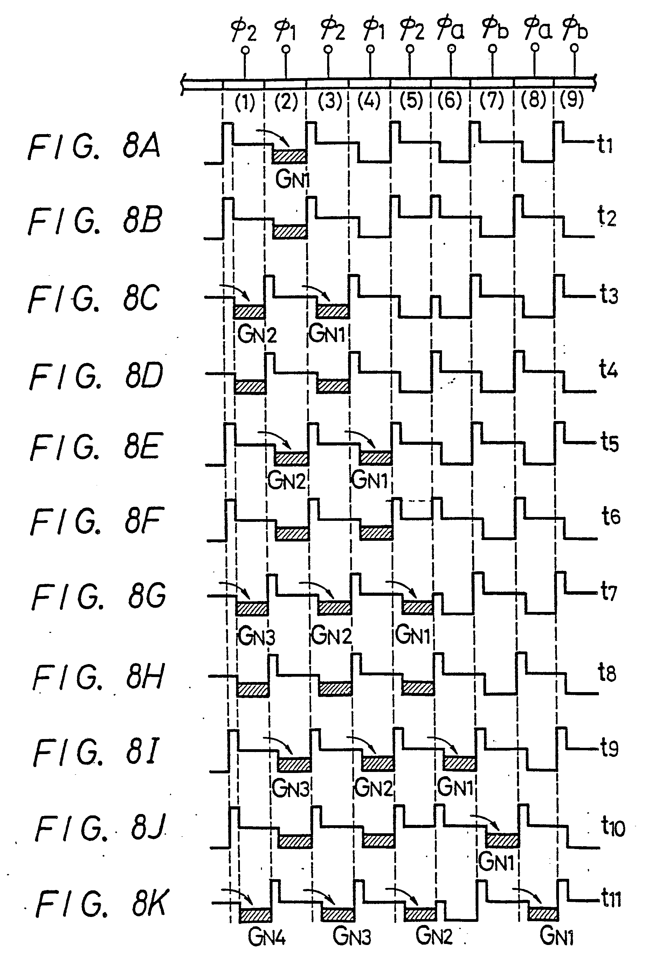

The operation of the charge transfer device 30 will be described with reference to Figures 7 and 8.

Figure 7 shows the transfer state of the delayed output GD at each time point shown in Figure 6, in which references GD1, GD2,... represent picture element information of the green signal G, each picture element information being delayed by 1H. Similarly, Figure 8 shows the transfer state of the non-delayed output GN at each time point shown in Figure 6, in which references GN1, GN2,... represent similar picture element information of the green signal G.

As will be clear from the Figures, the delayed output GD and the non-delayed output GN respectively transferred through the independent transfer channels 34 and 35 are alternately supplied in response to the clock pulses CKa and CKb after time point $t_9$, and then alternately transferred through the transfer channel 36. Thus, the outputs GD and GN are multiplexed to produce an output Go which comprises twice as much information.

Moreover, the signal processing is all carried out using signal charges, so that the above output circuit 14 and level adjusting circuit 15 can be omitted, and all the elements can be incorporated into one charge transfer element, thus enabling the signal processing circuit to be formed as one chip.

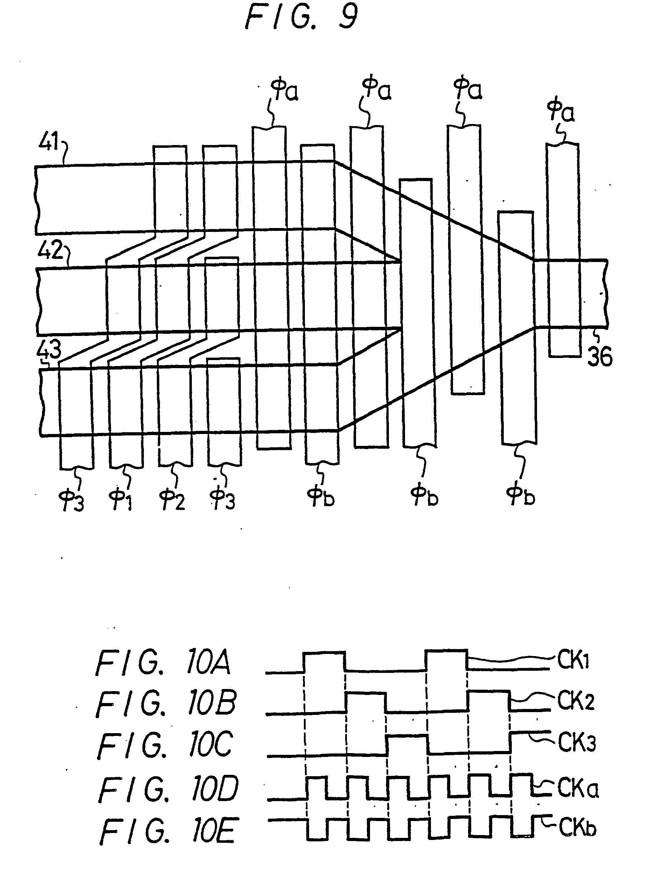

While the above embodiment, two transfer channels are provided to multiplex respective signals, a version as shown in Figure 9 is also possible, in which signal charges from three transfer channels 41 to 43 are multiplexed to produce a multiplexed output with a frequency three times as high. In this case, before the signal charges are multiplexed, they are transferred in response to 3-phase transfer clock pulses CK1 to CK3 shown in Figures 10A to 10C, while after the signal charges have been multiplexed, the signal charges are transferred in response to 2-phase clock pulses CKa and CKb shown in Figures 10D and 10E. The transfer state of the signals before being multiplexed is controlled so that the signals have a phase difference of 120°. Therefore, the alignment of the transfer electrodes $\phi 1$ and $\phi 2$ is as shown in Figure 9.

The invention can also be applied to other video processing circuits.

## Claims

1. A charge transfer device for multiplexing signals, the device comprising:

first and second charge coupled transfer channels (34, 35) for transferring signal charges along one direction and arranged in lines one below the other, each said channel (34, 35) having a plurality of transfer electrodes ($\phi 1$, $\phi 2$) extending over said channel (34, 35) transversely to the charge transport direction and being aligned with transfer electrodes ($\phi 1$, $\phi 2$) of the other channel (34, 35); and

a third charge coupled transfer channel (36) coupled to said first and second channels (34, 35) for transferring signal charges along the same direction and having a plurality of transfer electrodes ($\phi a$, $\phi b$) which extend transversely over said third channel (36) and over said first and second channels (34, 35) adjacent to the coupling region;

said transfer electrodes ($\phi 1$, $\phi 2$) of said first and second channels (34, 35) receiving first clock signals (CK1, CK2) with said respective aligned transfer electrodes ($\phi 1$, $\phi 2$) of both channels receiving said first clock signals at different phases; and

said transfer electrodes ($\phi a$, $\phi b$) of said third

channel (36) receiving second clock signals (CKa, CKb) which have a frequency twice that of said first clock signals (CK1, CK2);

whereby a pair of input signals supplied to said first and second channels (34, 35) are alternately supplied to said third channel (36) and thence to the output of said third channel (36).

2. A charge transfer device for multiplexing signals, the device comprising:

first, second and third charge coupled transfer channels (41, 42, 43) for transferring signal charges along one direction and arranged in lines one below the other;

a fourth charge coupled transfer channel (36) coupled to said first, second and third channels (41, 42, 43) for transferring signal charges along the same direction;

a first plurality of common transfer electrodes ($\phi 1$, $\phi 2$, $\phi 3$) extending transversely over said first, second and third channels (41, 42, 43), each of said first plurality of transfer electrodes ($\phi 1$, $\phi 2$, $\phi 3$) having portions offset from each other in charge transfer direction such that a particular transfer electrode portion over said first channel (41) is offset from a transfer electrode portion over said second channel (42) which in turn is offset from a transfer electrode portion over said third transfer channel (43), and transfer electrode portions over the respective channels (41, 42, 43) belonging to different transfer electrodes ($\phi 1$, $\phi 2$, $\phi 3$) being transversely aligned; and

a second plurality of transfer electrodes ($\phi a$, $\phi b$) extending transversely over said fourth channel (36) and over said first, second and third channels (41, 42, 43), only adjacent to where said first, second and third channels (41, 42, 43) are coupled to said fourth channel (36);

said first plurality of transfer electrodes ($\phi 1$, $\phi 2$, $\phi 3$) receiving first clock signals (CK1, CK2, CK3); and

said second plurality of transfer electrodes ($\phi a$, $\phi b$) receiving second clock signals (CKa, CKb) which have a frequency three times that of said first clock signals (CK1, CK2, CK3);

whereby a group of input signals supplied to said first, second and third channels (41, 42, 43) are alternately supplied to said fourth channel (36) and thence to the output of said fourth channel (36).

## Patentansprüche

1. Ladungsübertragungs-Vorrichtung zur Multiplexverarbeitung von Signalen, welche Vorrichtung umfaßt:

— einen ersten und einen zweiten ladungsgekoppelten Übertragungskanal (34, 35) zum Übertragen von Signalladungen längs einer Richtung und in Reihen eine unter der anderen angeordnet, wobei jeder Kanal (34, 35) eine Vielzahl von Übertragungselektroden ($\phi 1$, $\phi 2$) hat, die sich quer zu der Ladungstransportrichtung über den Kanal (34, 35) erstrecken und zu den Übertragungselektroden des anderen Kanals (34, 35) ausgerichtet sind, und

— einen dritten ladungsgekoppelten Übertragungskanal (36), der mit dem ersten und dem zweiten Kanal (34, 35) zum Übertragen von Signalladungen längs derselben Richtung gekoppelt ist und eine Vielzahl von Übertragungselektroden (φa, φb) hat, die sich quer über den dritten Kanal (36) und in Nachbarschaft des Kopplungsbereichs über den ersten und den zweiten Kanal (34, 35) erstrecken,

— wobei die Übertragungselektroden (φ1, φ2) des ersten und des zweiten Kanals (34, 35), die erste Taktsignale (CK1, CK2) mit den betreffenden ausgerichteten Übertragungselektroden (φ1, φ2) beider Kanäle aufnehmen, die ersten Taktsignale bei unterschiedlichen Phasenlagen aufnehmen, und

— wobei die Übertragungselektroden (φa, φb) des dritten Kanals (36) zweite Taktsignale (CKa, CKb) aufnehmen, die eine Frequenz haben, die das Zweifache derjenigen der ersten Taktsignale (CK1, CK2) beträgt,

— wodurch ein Paar von Eingangssignalen, die dem ersten und dem zweiten Kanal (34, 35) zugeführt werden, abwechselnd dem dritten Kanal (36) und demzufolge dem Ausgang des dritten Kanals (36) zugeführt werden.

2. Ladungsübertragungs-Vorrichtung zur Multiplexverarbeitung von Signalen, welche Vorrichtung umfaßt:

— einen ersten, einen zweiten und einen dritten ladungsgekoppelten Übertragungskanal (41, 42, 43) zum Übertragen von Signalladungen längs einer Richtung und in Reihen eine unter der anderen angeordnet,

— einen vierten ladungsgekoppelten Übertragungskanal (36), der mit dem ersten, dem zweiten und dem dritten Kanal (41, 42, 43) zum Übertragen von Signalladungen längs derselben Richtung gekoppelt ist,

— eine erste Vielzahl von gemeinsamen Übertragungselektroden (φ1, φ2, φ3), die sich quer über den ersten, den zweiten und den dritten Kanal (41, 42, 43) erstrecken, wobei jede der ersten Vielzahl von Übertragungselektroden (φ1, φ2, φ3) Abschnitte hat, die in Ladungsübertragungsrichtung derart gegeneinander versetzt angeordnet sind, daß ein bestimmter Übertragungselektrodenabschnitt über dem ersten Kanal (41) gegenüber einem Übertragungselektrodenabschnitt über dem zweiten Kanal (42) versetzt ist, der seinerseits gegenüber einem Übertragungselektrodenabschnitt über dem dritten Übertragungskanal (43) versetzt ist, und wobei Übertragungselektrodenabschnitte über den betreffenden Kanälen (41, 42, 43), die zu verschiedenen Übertragungselektroden (φ1, φ2, φ3) gehören, in Querrichtung zueinander ausgerichtet sind, und

— eine zweite Vielzahl von Übertragungselektroden (φa, φb), die sich quer über den vierten Kanal (36) und über den ersten, den zweiten und den dritten Kanal (41, 42, 43) nur in Nachbarschaft des Bereichs, in dem der erste, der zweite und der dritte Kanal (41, 42, 43) mit dem vierten Kanal (36) gekoppelt sind, erstrecken,

— wobei die erste Vielzahl von Übertragungselektroden (φ1, φ2, φ3) erste Taktsignale (CK1, CK2, CK3) aufnimmt und

— wobei die zweite Vielzahl von Übertragungselektroden (φa, φb) zweite Taktsignale (CKa, CK2) aufnimmt, die eine Frequenz haben, welche das Dreifache derjenigen der ersten Taktsignale (CK1, CK2, CK3) beträgt, wodurch Eingangssignale einer Gruppe, die dem ersten, dem zweiten und dem dritten Kanal (41, 42, 43) zugeführt werden, abwechselnd dem vierten Kanal (36) und demzufolge dem Ausgang des vierten Kanals (36) zugeführt werden.

## Revendications

1. Un dispositif à transfert de charge pour le multiplexage de signaux, ce dispositif comprenant:

des premier et second canaux de transfert à couplage de charge (34, 35) qui sont destinés à transférer des charges de signal dans une direction et qui sont disposés en lignes l'un au-dessous de l'autre, chaque canal (34, 35) comportant un ensemble d'électrodes de transfert (φ1, φ2) qui s'étendent sur le canal (34, 35), transversalement à la direction de transport de charge, et qui sont alignées avec des électrodes de transfert (φ1, φ2) de l'autre canal (34, 35); et

un troisième canal de transfert à couplage de charge (36) qui est couplé aux premier et second canaux (34, 35), pour transférer des charges de signal dans la même direction et qui comprend un ensemble d'électrodes de transfert (φa, φb) qui s'étendent transversalement sur le troisième canal (36) et sur les premier et second canaux (34, 35) au voisinage de la région de couplage;

les électrodes de transfert (φ1, φ2) des premier et second canaux (34, 35) recevant des premiers signaux d'horloge (CK1, CK2), de façon que les électrodes de transfert alignées respectives (φ1, φ2) des deux canaux reçoivent les premiers signaux d'horloge avec des phases différentes; et

les électrodes de transfert (φa, φb) du troisième canal (36) recevant des seconds signaux d'horloge (CKa, CKb) qui ont une fréquence double de celle des premiers signaux d'horloge (CK1, CK2);

grâce à quoi une paire de signaux d'entrée qui sont appliqués aux premier et second canaux (34, 35) sont alternativement appliqués au troisième canal (36), et de là à la sortie du troisième canal (36).

2. Un dispositif à transfert de charge pour le multiplexage de signaux, ce dispositif comprenant:

des premier, second et troisième canaux de transfert à couplage de charge (41, 42, 43) qui sont destinés à transférer des charges de signal dans une direction et qui sont disposés en lignes les uns au-dessous des autres;

— un quatrième canal de transfert à couplage de charge (36) qui est couplé aux premier, second et troisième canaux (41, 42, 43) pour transférer des charges de signal dans la même direction;

un premier ensemble d'électrodes de transfert

communes ($\phi$1, $\phi$2, $\phi$3) qui s'étendent transversalement sur les premier, second et troisième canaux (41, 42, 43), chacune des électrodes du premier ensemble d'électrodes de transfert ($\phi$1, $\phi$2, $\phi$3) comportant des parties décalées par rapport à chacune des autres, dans la direction de transfert de charge, de façon qu'une partie d'électrode de transfert particulière sur le premier canal (41) soit décalée par rapport à une partie d'électrode de transfert sur le second canal (42) qui est décalée à son tour par rapport à une partie d'électrode de transfert sur le troisième canal de transfert (43), et des parties d'électrodes de transfert sur les canaux respectifs (41, 42, 43) appartenant à des électrodes de transfert différentes ($\phi$1, $\phi$2, $\phi$3) qui sont alignées transversalement; et

un second ensemble d'électrodes de transfert ($\phi$a, $\phi$b) qui s'étendent transversalement sur le quatrième canal (36) et sur les premier, second et troisième canaux (41, 42, 43), seulement au voisinage de l'endroit auquel les premier, second et troisième canaux (41, 42, 43) sont couplés au quatrième canal (36);

le premier ensemble d'électrodes de transfert ($\phi$1, $\phi$2, $\phi$3) recevant des premiers signaux d'horloge (CK1, CK2, CK3); et

le second ensemble d'électrodes de transfert ($\phi$a, $\phi$b) recevant des seconds signaux d'horloge (CKa, CKb) qui ont une fréquence trois fois supérieure à celle des premiers signaux d'horloge (CK1, CK2, CK3);

grâce à quoi un groupe de signaux d'entrée qui sont appliqués aux premier, second et troisième canaux (41, 42, 43) sont alternativement appliqués au quatrième canal (36), et de là à la sortie du quatrième canal (36).

FIG. 1A

$S_A$

fc1

FIG. 1B

$S_B$

fc1

FIG. 1C

$S_C$

fc2

FIG. 2

$\underline{1}$

→ H

| G | R | G | R | G | R |
|---|---|---|---|---|---|
| B | G | B | G | B | G |
| G | R | G | R | G | R |

V

$2_H$

FIG. 3

GN

| 1H DL | | | G. CTL |

GD

13

11

14

$\underline{10}$

15

12

OUT

GN

FIG. 4

FIG. 6A — CK1

FIG. 6B — CK2

FIG. 6C — CKa

FIG. 6D — CKb

# FIG. 5

FIG. 7A

FIG. 7B

FIG. 7C

FIG. 7D

FIG. 7E

FIG. 7F

FIG. 7G

FIG. 7H

FIG. 7I

FIG. 7J

4

EP 0 109 445 B1

FIG. 8A
FIG. 8B
FIG. 8C
FIG. 8D
FIG. 8E
FIG. 8F
FIG. 8G
FIG. 8H
FIG. 8I
FIG. 8J
FIG. 8K

# FIG. 9

# FIG. 10A — CK1
# FIG. 10B — CK2
# FIG. 10C — CK3
# FIG. 10D — CKa
# FIG. 10E — CKb